(19) **Europäisches Patentamt**
**European Patent Office**
**Office européen des brevets**

(11) **EP 2 878 978 B1**

(12) **EUROPEAN PATENT SPECIFICATION**

(45) Date of publication and mention
of the grant of the patent:
**28.11.2018 Bulletin 2018/48**

(51) Int Cl.:
*G02B 5/02* *(2006.01)*    *F21V 3/04* *(2018.01)*
*H01L 51/52* *(2006.01)*    *H05B 33/02* *(2006.01)*

(21) Application number: **13823670.8**

(22) Date of filing: **17.07.2013**

(86) International application number:
**PCT/JP2013/069450**

(87) International publication number:
**WO 2014/017363 (30.01.2014 Gazette 2014/05)**

(54) **OPTICAL SHEET AND SURFACE LIGHT SOURCE APPARATUS**

OPTISCHE FOLIE UND OBERFLÄCHENLICHTQUELLENVORRICHTUNG

PLAQUE OPTIQUE ET APPAREIL À SOURCE LUMINEUSE SUPERFICIELLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.07.2012 JP 2012167601**

(43) Date of publication of application:
**03.06.2015 Bulletin 2015/23**

(73) Proprietor: **Zeon Corporation
Tokyo 100-8246 (JP)**

(72) Inventor: **INOUE, Hiroyasu
Tokyo 100-8246 (JP)**

(74) Representative: **Maiwald Patent- und
Rechtsanwaltsgesellschaft mbH
Elisenhof
Elisenstraße 3
80335 München (DE)**

(56) References cited:
**WO-A1-2011/078092    WO-A1-2011/078092
JP-A- 2007 114 760    JP-A- 2012 069 257
US-A1- 2006 134 400**

**Description**

Field

The present invention relates to an optical sheet and a surface light source device including an organic electroluminescent (referred to hereinbelow as organic EL) element.

Background

An organic EL element in which an organic light-emitting layer is disposed between a plurality of electrode layers to electrically obtain light emission is being studied for its use as a display device as an alternative to liquid crystal cells. Use of the organic EL devices as surface light source devices such as flat lighting devices and the backlights for liquid crystal displays is also being studied for utilizing its characteristics such as high light-emitting efficiency, low-driving voltage, light weight, and low cost.

When an organic EL element is used as a light source of a surface light source device, it is necessary to extract light from the element in a useful form at high efficiency. For example, although the light-emitting layer of the organic EL element itself has high light-emitting efficiency, the loss of light during the passage and emission of the light through the layers constituting the element may become significant depending on some conditions such as degree of refractive index difference between the layers. Therefore, there is a demand for reducing the loss of light as much as possible.

One known method for improving the light extraction efficiency of a light source device is to provide an optical sheet including a plurality of layers having specific optical property on the light extraction surface side of the light source device (for example, Patent Literature 1). By providing such an optical sheet, it is expected to improve the light extraction efficiency and reduce the change in color tone at different viewing angles.

Citation List

Patent Literature

Patent Literature 1: International Patent Publication No. 2011/078092

Summary

Technical Problem

A possible strategy for improving the efficiency of light extraction from a light-emitting element is to use high-refractive index glass as the substrate. With the use of the high-refractive index glass as the substrate, it is expected to improve the efficiency of light extraction from the light-emitting layer having a high refractive index of about 1.8 to the substrate. However, use of such high-refractive index glass substrate may increase difficulty of light emission from the high-refractive index glass substrate to another layer or to the outside of the device.

A possible strategy for improving the efficiency of the light extraction from the high-refractive index glass is to use an optical sheet whose layer in direct contact with the glass substrate has light diffusibility. For example, when an optical sheet including a transparent substrate and an adhesive layer having a high refractive index and light diffusibility is used, the extraction efficiency may be improved.

However, when such a light diffusion adhesive layer having a high refractive index is formed, the viscosity of the material forming this layer is likely to deviate from a viscosity appropriate for coating, and this may result in unevenness of the adhesive layer. Such unevenness is recognized as surface unevenness when the light-emitting surface of a surface light source device is observed, and deteriorates the quality of the surface light source device.

Accordingly, it is an object of the present invention to provide an optical sheet that can improve the light extraction efficiency of a surface light source device, can reduce the change in color tone at different viewing angles, and can reduce the occurrence of surface unevenness. It is also an object to provide a surface light source device which has high light extraction efficiency and in which a change in color tone at different viewing angles and surface unevenness are small.

Solution to Problem

The present inventor has conducted studies for solving the aforementioned problems, and reached a conception of using an optical sheet including, in addition to a light diffusion adhesive layer, a light diffusion layer having specific features. Specifically, the present inventor has found out that the use of an optical sheet including a transparent substrate, a light diffusion layer disposed on one side of the transparent substrate and having features such as a specific haze, and a light diffusion adhesive layer disposed on the other side can reduce visual recognition of surface unevenness caused by unevenness of the light diffusion adhesive layer while the light extraction efficiency is improved by the light diffusion adhesive layer. Thus the present invention has been completed.

That is, according to the present invention, the following [1] to [6] are provided.

(1) An optical sheet comprising a transparent substrate, a light diffusion layer having a concavo-convex surface structure and disposed on one side of the transparent substrate, and a light diffusion adhesive layer disposed on the other side of the transparent substrate, wherein

the light diffusion layer contains a resin and first diffusion particles having a number average particle diameter of 1.7 $\mu$m or more,

the light diffusion adhesive layer contains a binder, high-refractive index nanoparticles, and second diffusion particles, a haze x1(%) of the light diffusion layer and a haze x2(%) of the light diffusion adhesive layer satisfy a relationship x1 > x2,

the haze x1 is 98.5% or higher, and

the high-refractive index nanoparticles are particles having a refractive index of 1.68 or higher.

(2) The optical sheet according to (1), wherein the second diffusion particles have a number average particle diameter of 0.3 to 1.7 $\mu$m.

(3) The optical sheet according to any one of (1) to (2), wherein the high-refractive index nanoparticles are particles formed of an inorganic material or particles each having a core formed of an inorganic material and an organic coating covering an outer surface of the core, and the second diffusion particles are particles formed of an organic material.

(4) The optical sheet according to any one of (1) to (3), wherein the second diffusion particles are particles having a refractive index of lower than 1.55.

(5) The optical sheet according to any one of (1) to (4), wherein, in the light diffusion adhesive layer, a refractive index n2 of the second diffusion particles and a refractive index n1 of the rest of the components of the light diffusion adhesive layer satisfy a relationship n1 > n2.

(6) A surface light source device comprising the optical sheet according to any one of (1) to (5) and an organic electroluminescent light-emitting element.

Advantageous Effects of Invention

The optical sheet of the present invention can improve light extraction efficiency of a surface light source device, can reduce change in color tone at different viewing angles, and can reduce occurrence of surface unevenness. The surface light source device of the present invention has high light extraction efficiency, causes small color tone change at different viewing angles, and has low surface unevenness.

Brief Description of Drawings

FIG. 1 is a cross-sectional view schematically illustrating an example of the optical sheet of the present invention.
FIG. 2 is a perspective view schematically illustrating another example of the optical sheet of the present invention.
FIG. 3 is a cross-sectional view of the optical sheet shown in FIG. 2, illustrating a cross section obtained by cutting the optical sheet along a plane that passes through line 1a-1b in FIG. 2 and is perpendicular to a plane direction of a transparent substrate.
FIG. 4 is a cross-sectional view schematically illustrating an example of the surface light source device of the present invention.

Description of Embodiments

The present invention will be described in detail by way of embodiments and exemplifications. However, the present invention is not limited to the following embodiments and exemplifications and may be implemented with any modifications without departing from the scope of the claims and equivalents thereto.

<Optical sheet>

The optical sheet of the present invention includes a transparent substrate, a light diffusion layer disposed on one side of the transparent substrate, and a light diffusion adhesive layer disposed on the other side of the transparent substrate.

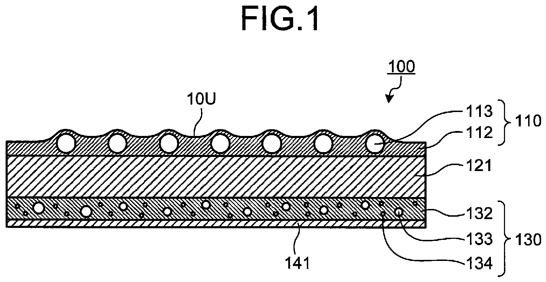

FIG. 1 is a cross-sectional view schematically illustrating an example of the optical sheet of the present invention. In FIG. 1, the optical sheet 100 includes a transparent substrate 121, a light diffusion layer 110 disposed in direct contact with one surface of the transparent substrate 121, and a light diffusion adhesive layer 130 disposed in direct contact with the other surface of the transparent substrate 121. In this embodiment, the light diffusion layer and the light diffusion adhesive layer are disposed directly on the surfaces of the transparent substrate. However, the optical sheet of the present invention is not limited to such an embodiment, and another layer may be interposed between the transparent substrate and the light diffusion layer or the light diffusion adhesive layer.

The light diffusion layer 110 contains a resin 112 and first diffusion particles 113, and the surface 10U of the light diffusion layer 110 has a concavo-convex structure due to the presence of the first diffusion particles 113. The light diffusion adhesive layer contains a binder 132, second diffusion particles 133, and high-refractive index nanoparticles 134. Since the surface of the light diffusion adhesive layer 130 is an adhesive surface, the optical sheet 100 is stored with a separator 141 attached to the adhesive surface, if necessary. The optical sheet 100 may be used after the separator 141 is removed.

(Transparent substrate)

In the present invention, the term "transparent" regarding the transparent substrate means that the transparent substrate has a light transmittance suitable for use as a material for an optical sheet. In the present invention, each of the layers constituting the optical sheet may have a light transmittance suitable for use in an optical member, and the total light transmittance of the overall optical sheet may be 50% or higher.

Examples of the material of the transparent substrate for use may include glass and a variety of resins that is capable of forming a transparent layer. Examples of the material of the transparent substrate may include thermoplastic resins, thermosetting resins, UV curable resins, and electron ray-curable resins. Of these, thermoplastic resins are preferable because they can be easily processed. Examples of the thermoplastic resins may include polyester-, polyacrylate-, and cycloolefin polymer-based resins. The transparent substrate is not limited to a single-layer substrate and may be a stack of a plurality of transparent substrates.

A transparent substrate having a higher refractive index is preferable because the efficiency of light extraction from the light diffusion adhesive layer to the transparent substrate becomes higher. However, in the present invention, a specific light diffusion adhesive layer is used, and this allows high light extraction efficiency to be achieved even when the refractive index of the transparent substrate is lower than that of the light diffusion adhesive layer. Therefore, the material of the transparent substrate is not limited to a high-refractive index material and may be appropriately selected from viewpoints of, e.g., cost and properties other than the refractive index. Specifically, the refractive index of the transparent substrate is preferably 1.4 or higher and more preferably 1.5 or higher and is preferably 1.9 or lower and more preferably 1.7 or lower.

In the present application, the refractive index of each layer may be measured with a sample of a single-layer or multi-layer sheet using a spectroscopic ellipsometer (M-2000, manufactured by J. A. Woollam Co., Inc.).

In the optical sheet of the present invention, when the transparent substrate is made of, e.g., a resin, the thickness of the transparent substrate is preferably 20 to 300 $\mu$m. When the transparent substrate is made of glass, its thickness is preferably 10 to 1,100 $\mu$m. The optical sheet of the present invention is referred to as a "sheet" because the optical sheet has a thin flat plate-like structure. However, the optical sheet is not necessarily required to be flexible. Therefore, e.g., the optical sheet of the present invention may include a non-flexible layered body adopting a glass transparent substrate having a thickness of 700 $\mu$m.

(Light diffusion layer)

The light diffusion layer is a layer disposed on one side of the transparent substrate. When the optical sheet of the present invention is provided in a surface light source device, the light diffusion layer is usually located on a light-emission side (i.e., on the side farther from a light-emitting layer than the light diffusion adhesive layer and the transparent substrate in the optical sheet). The light diffusion layer may be disposed directly on the surface of the transparent substrate or may be disposed via an optional layer. It is preferable from the viewpoint of the ease of production that the light diffusion layer is disposed directly on the transparent substrate.

The light diffusion layer contains a resin and first diffusion particles having a specific number average particle diameter.

Examples of the resin contained in the light diffusion layer may include thermoplastic resins, thermosetting resins, and energy ray curable resins such as UV curable resins and electron beam curable resins. Of these, thermosetting resins and energy ray curable resins are preferable from the viewpoint of their high hardness and production efficiency.

Examples of the thermoplastic resins may include polyester-, polyacrylate-, and cycloolefin polymer-based resins. Examples of the UV curable resins may include epoxy-, acrylic-, urethane-, ene/thiol-, and isocyanate-based resins. As these resins, those having a plurality of polymerizable functional groups may be preferably used.

The first diffusion particles contained in the light diffusion layer may be transparent and may also be non-transparent. Examples of the material of the first diffusion particles may include metals, metal compounds, and resins. Examples of the metal compounds may include metal oxides and nitrides. Specific examples of the metal and metal compounds may include: high reflectivity metals such as silver and aluminum; and metal compounds such as silicon oxide, aluminum oxide, zirconium oxide, silicon nitride, tin-doped indium oxide, and titanium oxide. Examples of the resins may include methacrylic resins, polyurethane resins, silicone resins, and melamine resins.

No particular limitation is imposed on the shape of the first diffusion particles, and the first diffusion particles may have a shape such as a spherical, cylindrical, cubic, cuboidal, pyramid, conical, or star-like shape.

The first diffusion particles have a number average particle diameter of 1.7 $\mu$m or more. The number average particle diameter may be measured using any of various particle size distribution meters (for example, a centrifugal sedimentation particle size distribution meter CAPA-700, HORIBA Ltd.). When the number average particle diameter is equal to or larger than the aforementioned lower limit, a concavo-convex structure can be formed on the surface of the light diffusion layer. When the light diffusion layer has a concavo-convex structure, the light extraction efficiency can be improved. When the shape of the particles is other than spherical, the diameters of spheres having the same volumes as those of the particles are used as their particle diameters. No particular limitation is imposed on the upper limit of the number average particle diameter of the first diffusion particles, although the number average particle diameter may be 30 $\mu$m or less.

When the first diffusion particles are transparent particles, the difference between the refractive index of the first diffusion particles and the refractive index of the resin constituting the light diffusion layer is preferably 0.05 to 0.5 and more preferably 0.07 to 0.5. Either of the first diffusion particles and the resin may have a higher refractive index than the other. If the refractive index of the first diffusion particles is too close to that of the resin, the diffusion effect may not be obtained, and suppression of color tone unevenness may be failed. If the difference is too large, although high diffusion may be obtained and color tone unevenness may be suppressed, the light extraction effect may be reduced.

The ratio of the resin and the first diffusion particles contained in the light diffusion layer is preferably 3 to 50% by weight in terms of the ratio of the amount of the first diffusion particles with respect to the total amount of the resin and the first diffusion particles.

(Optional components)

If necessary, the light diffusion layer may contain, in addition to the resin and the first diffusion particles, optional components. Examples of the optional components may include an antistatic agent, a cross-linking agent, a UV absorber, a fluorescent agent, and a phosphorescent agent.

(Properties and shape of light diffusion layer)

It is preferable that the refractive index of the light diffusion layer is higher than the refractive index of the transparent substrate.

No particular limitation is imposed on the size of the surface concavo-convex structure of the light diffusion layer, although the arithmetic average roughness Ra of the concavo-convex surface structure is preferably 0.15 $\mu$m or more.

In the optical sheet of the present invention, the lower limit of the thickness of the light diffusion layer is preferably 1 $\mu$m or more and more preferably 3 $\mu$m or more, and the upper limit is preferably 50 $\mu$m or less and more preferably 20 $\mu$m or less. When the thickness is equal to or less than the upper limit, the surface concavo-convex structures due to the first diffusion particles can be preferably formed.

(Light diffusion adhesive layer)

The light diffusion adhesive layer is disposed on the surface of the transparent substrate that is opposite to the surface on which the light diffusion layer is disposed. When the optical sheet of the present invention is provided in a surface light source device, the light diffusion adhesive layer is usually located on the light-incident side (i.e., the side closer to the light-emitting layer than the light diffusion layer and the transparent substrate). The light diffusion adhesive layer may be disposed directly on the surface of the transparent substrate or may be disposed via another layer. It is preferable from the viewpoint of the ease of production that the light diffusion adhesive layer is disposed directly on the transparent substrate.

The light diffusion adhesive layer is an adhesive layer having light diffusibility. That is, the light diffusion adhesive layer has, in addition to the function of diffusing light passing through the optical sheet, the function of effecting adhesion of the optical sheet to another layer in an organic EL element. When the light diffusion adhesive layer is an adhesive layer, the optical sheet of the present invention can be easily disposed on an organic EL element. In addition, the light extraction efficiency can be improved as a result of simplified layer structure of the organic EL element.

The light diffusion adhesive layer contains a binder, high-refractive index nanoparticles, and second diffusion particles. When the optical sheet of the present invention is used as a constituent of a surface light source device, the light diffusion adhesive layer is usually in direct contact with the substrate of the organic EL element. The substrate of the organic EL element may be made of high-refractive index glass in order to improve the efficiency of light extraction from the light-emitting element. In such a case, when the light diffusion adhesive layer contains high-refractive index nanoparticles and is therefore a layer having a high refractive index, the efficiency of light extraction from the substrate to the light diffusion adhesive layer can be improved. When the light diffusion adhesive layer further contains second diffusion particles, light that has entered into the light diffusion adhesive layer is diffused, and therefore the efficiency of light extraction from the light diffusion adhesive layer to the transparent substrate can be improved even when the refractive index of the transparent substrate is not so high.

Examples of material for the binder contained in the light diffusion adhesive layer may include epoxy resins, (meth)acrylic resins, silicone resins, urethane resins, polyimide resins, acid-modified polyolefins, aliphatic hydrocarbon resins, and mixtures thereof. Use of any of the aforementioned resins can facilitate production of the light diffusion adhesive layer, and can impart functions as the adhesive layer to the light diffusion adhesive layer.

Examples of the high-refractive index nanoparticles contained in the light diffusion adhesive layer may include particles formed of inorganic materials and particles formed of organic materials having a refractive index of 1.68 or higher. Examples of the inorganic materials may include: nanoparticles of oxides such as zirconia, titania, tin oxide, and zinc oxide; nanoparticles of titanates such as barium titanate and strontium titanate; and nanoparticles of sulfides, selenides, and tellurides such as CdS, CdSe, ZnSe, CdTe, ZnS, HgS, HgSe, PdS, and SbSe. Examples of the organic materials having a refractive index of 1.68 or more may include styrene-based resins. The surface of these nanoparticles may be modified with any of a variety of functional groups, a silane coupling agent, etc. for improving dispersibility. No particular limitation is imposed on the upper limit of the refractive index of the high-refractive index nanoparticles, although the refractive index may be 3.0 or less.

No particular limitation is imposed on the shape of the high-refractive index nanoparticles, and the high-refractive index nanoparticles may have a shape such as a spherical, cylindrical, cubic, cuboidal, pyramid, conical, or star-like shape.

The number average particle diameter of the high-refractive index nanoparticles is preferably 1 nm or more and more preferably 5 nm or more and is preferably 200 nm or less and more preferably 100 nm or less. When the number average particle diameter is within the aforementioned range, the effect of increasing the refractive index can be favorably obtained.

The containing ratio of the high-refractive index nanoparticles in the light diffusion adhesive layer, as the ratio of the weight of the high-refractive index nanoparticles with respect to the total weight of the binder, the high-refractive index nanoparticles, and the second diffusion particles, is preferably 20% by weight or more and more preferably 30% by weight or more and is preferably 80% by weight or less and more preferably 70% by weight or less.

Examples of the material of the second diffusion particles contained in the light diffusion adhesive layer may include organic materials, particularly organic materials having a refractive index of less than 1.55, and preferred examples thereof may include silicone resins and acrylic-based cross-linked particles having a refractive index of less than 1.5. More specifically, a material having properties such as refractive index within desired ranges may be appropriately selected from those exemplified in the above as the material of the second diffusion particles. No particular limitation is imposed on the lower limit of the refractive index of the second diffusion particles, although the refractive index may be 1.3 or higher.

The number average particle diameter of the second diffusion particles is preferably 0.3 $\mu$m or more and more preferably 0.5 $\mu$m or more and is preferably 1.7 $\mu$m or less and more preferably 1 $\mu$m or less. When the number average particle diameter is within the aforementioned range, the effects of the present invention can be favorably obtained. Particularly, when second diffusion particles having a small number average particle diameter are used, light that has impinged on the particles is then highly scattered. However, since a large number of gaps are present between the particles in the layer, the amount of light that is not scattered and passes linearly through the light diffusion adhesive layer also becomes large. Therefore, a number average particle diameter equal to or less than the aforementioned upper limit is particularly preferable because thereby high diffusion can be obtained while an increase in haze is suppressed.

The containing ratio of the second diffusion particles in the light diffusion adhesive layer, as the ratio of the weight of the second diffusion particles with respect to the total weight of the binder, the high-refractive index nanoparticles, and the second diffusion particles, is preferably 1% by weight or more and more preferably 3% by weight or more and is preferably 30% by weight or less and more preferably 20% by weight or less.

(Optional components)

If necessary, the light diffusion adhesive layer may contain, in addition to the binder, the high-refractive index nanoparticles, and the second diffusion particles, optional components. Examples of the optional components may include a variety of additives such as a tackifier, a curing agent, a plasticizer, and a UV absorber.

(Properties and shape of light diffusion adhesive layer)

The refractive index of the light diffusion adhesive layer may be appropriately set in accordance with the intended use of the optical sheet. Particularly, when the optical sheet of the present invention is used by attaching it to the substrate of an organic EL element, it is preferable that the refractive index of the light diffusion adhesive layer is higher than the refractive index of the substrate. However, a lower refractive index is preferable from the viewpoint of production cost. Specifically, the refractive index of the transparent substrate is preferably 1.57 or higher and more preferably 1.6 or higher and is preferably 1.9 or lower and more preferably 1.8 or lower. The refractive index within the aforementioned range may be obtained by adjusting mainly the ratio of the high-refractive index nanoparticles.

Preferably, in the light diffusion adhesive layer, the refractive index $n2$ of the second diffusion particles and the refractive index $n1$ of the rest of the components of the light diffusion adhesive layer satisfy the relationship $n1 > n2$.

The rest of the components are components other than the second diffusion particles among the components constituting the light diffusion adhesive layer. The refractive index $n1$ of the rest of the components may be determined as follows. Separately from the light diffusion adhesive layer formed, components other than the second diffusion particles are used in the same amounts as those used for producing the light diffusion adhesive layer to form a layer in the same manner as that for the light diffusion adhesive layer except that no second diffusion particles are added. Then the refractive index of the formed layer is measured. Alternatively, the refractive index $n1$ may be roughly estimated using the optical properties of the main components (the binder and the high-refractive index nanoparticles) constituting the rest of the components and the mixing ratio of these components.

The lower limit of the thickness of the light diffusion adhesive layer is preferably 1 $\mu$m or more and more preferably 10 $\mu$m or more and may be 30 $\mu$m or more or 40$\mu$m or more, and the upper limit is preferably 100 $\mu$m or less and more preferably 60 $\mu$m or less.

(Haze relationship)

In the optical sheet of the present invention, the haze $x1$ (%) of the light diffusion layer and the haze $x2$ (%) of the light diffusion adhesive layer satisfy the relationship $x1 > x2$.

The haze $x1$ and the haze $x2$ may be measured as follows. A light diffusion layer or a light diffusion adhesive layer is formed on a transparent substrate as the measurement object, and the haze of the formed layer is measured. The measurement device for use may be a commercial turbidimeter (for example, NDH-4000 manufactured by NIPPON DENSHOKU INDUSTRIES Co., Ltd.) in accordance with JIS K7105.

When the haze $x1$ and the haze $x2$ satisfy the relationship $x1 > x2$, both an improvement in light extraction efficiency and a reduction in surface unevenness can be achieved.

Specifically, for improving light extraction efficiency, it is necessary that the light diffusion adhesive layer contain a large amount of the high-refractive index nanoparticles and a large amount of the second diffusion particles. However, when the light diffusion adhesive layer contains a large amount of these particles, the viscosity of the material for forming the light diffusion adhesive layer becomes high, and the degree of dispersion of the particles in the material becomes low, so that unevenness tends to occur. By adjusting the haze $x1$ of the light diffusion layer and the haze $x2$ of the light diffusion adhesive layer such that $x1 > x2$, the unevenness of the light diffusion adhesive layer is hidden when the light diffusion adhesive layer is observed at the light-emitting surface. Therefore, a reduction in surface unevenness can be achieved while the light extraction efficiency is improved.

According to the invention the aforementioned requirement is met. According to the invention $x1$ is 98.5% or higher and more preferably 98.7% or higher and is preferably 99.7% or lower and more preferably 99.5% or lower. Particularly, when $x1$ is equal to or higher than the aforementioned lower limit, reduction in surface unevenness can be favorably achieved.

When only the light diffusion layer and the light diffusion adhesive layer have haze in the optical sheet of the present invention, the haze of the overall optical sheet is approximately the same as a value calculated using $x1$ and $x2$ as follows.

```
    Haze of the overall optical sheet (calculated value,
 %) = x1 + (100 - x1) * (x2 / 100)
```

No particular limitation is imposed on the haze of the overall optical sheet of the present invention, although the haze is preferably 98.5% or higher and more preferably 98.7% or higher and is preferably 99.7% or lower and more preferably 99.5% or lower.

(Concavo-convex structure)

In the optical sheet of the present invention, the surface concavo-convex structure of the light diffusion layer may be a concavo-convex structure based on the shape of the first diffusion particles. However, in addition to or in place of such a concavo-convex structure, the light diffusion layer may have a concavo-convex structure formed using a mold such as a metal mold.

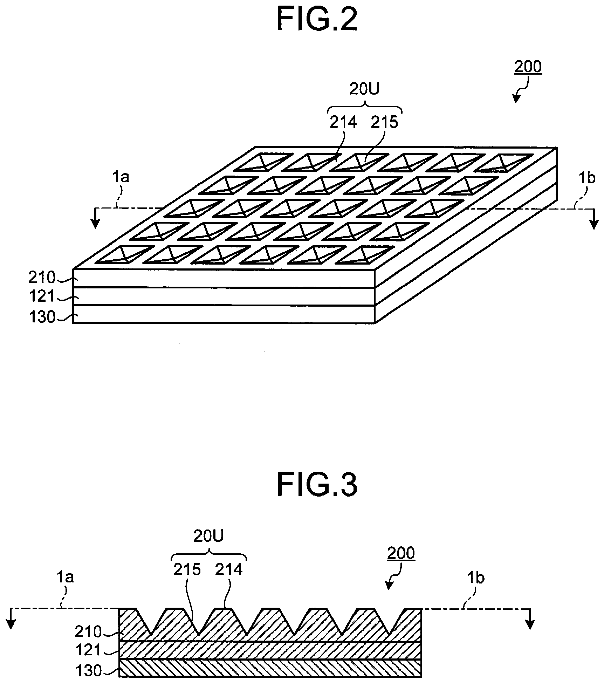

FIG. 2 is a perspective view schematically showing an example of the optical sheet of the present invention having a surface concavo-convex structure formed using a mold, and FIG. 3 is a cross-sectional view of the optical sheet shown in FIG. 2, illustrating a cross section obtained by cutting the optical sheet along a plane that passes through line 1a-1b in FIG. 2 and is perpendicular to a plane direction of the transparent substrate. The optical sheet 200 is different from the optical sheet 100 shown in FIG. 1 in that a light diffusion layer 210 having a surface concavo-convex structure formed using a mold is provided as the light diffusion layer in place of the light diffusion layer 110 shown in FIG. 1, and the other features of the optical sheet 200 are the same as those of the optical sheet 100. The light diffusion layer 210 has, on its upper surface, a concavo-convex structure including a plurality of concave portions 215 and flat portions 214 located around the concave portions 215. By such a concavo-convex structure, a surface 20U of the optical sheet 200 is defined. The effect of improving the light extraction efficiency etc. can also be obtained by such a concavo-convex surface structure formed using a mold. The concavo-convex structure formed using a mold is not limited to the structure including quadrangular pyramid-shaped dents shown in FIGs. 2 and 3 and may include any other shape. For example, a pyramid shape other than the quadrangular pyramid shape, a conical shape, the shape of part of a sphere, a groove shape, or a combination of any of these shapes may be used. The conical and pyramid shapes may be not only ordinary conical and pyramid shapes having sharp apexes but also conical and pyramid shapes having rounded apexes and conical and pyramid shapes having flat truncated apexes.

(Production method)

The optical sheet of the present invention may be produced, e.g., by: preparing a coating liquid (1) suitable for forming the light diffusion layer and a coating liquid (2) suitable for forming the light diffusion adhesive layer; and forming the light diffusion layer and the light diffusion adhesive layer on both sides of the transparent substrate using these coating liquids.

(Method for forming light diffusion layer)

As the coating liquid (1) suitable for forming the light diffusion layer, a composition containing any of the aforementioned resins for the material of the light diffusion layer and any of the aforementioned first diffusion particles may be used. If necessary, the coating liquid (1) may contain a solvent. Examples of the solvent may include toluene, hexane, cyclohexane, methylcyclohexane, methyl ethyl ketone, ethyl acetate, and mixtures thereof. When the coating liquid (1) contains the resin, the first diffusion particles, and the solvent, the ratio of the weight of the solvent with respect to the total weight of the coating liquid (1) may be 10 to 80% by weight.

The light diffusion layer may be obtained by applying the coating liquid (1) onto the surface of the transparent substrate, volatilizing the solvent if necessary, and then performing curing treatment by, e.g., irradiation with energy rays, if necessary. The solvent may be volatilized by, e.g., heating the applied coating liquid (1) for a specific time in a specific temperature range. The heating temperature is preferably 40 to 200°C and more preferably 40 to 140°C. The heating time is preferably 15 to 600 seconds.

The concavo-convex surface structure of the light diffusion layer may be obtained as a structure in line with the shape of the first diffusion particles by appropriately selecting the number average particle diameter of the first diffusion particles and the thickness of the light diffusion layer. Alternatively, the surface concavo-convex structure may be formed by preparing a mold such as a metal mold having a desired shape and then transferring the shape of the mold in any stage after the coating layer is obtained.

(Method for forming light diffusion adhesive layer)

As the coating liquid (2) suitable for forming the light diffusion adhesive layer, a composition containing any of the aforementioned resins for the material of the light diffusion adhesive layer, any of the aforementioned high-refractive index nanoparticles, and any of the aforementioned second diffusion particles may be used. Preferably, the coating liquid (2) may further contain a solvent. Examples of the solvent may include toluene, hexane, cyclohexane, methylcyclohexane, methyl ethyl ketone, ethyl acetate, and mixtures thereof. When the coating liquid (2) contains the resin, the high-refractive index nanoparticles, and the second diffusion particles, the ratio of the weight of the solvent with respect to the total weight of the coating liquid (2) may be 30 to 85% by weight.

The light diffusion adhesive layer may be obtained by applying the coating liquid (2) onto the surface of the transparent substrate, volatilizing the solvent, if necessary, and then performing curing treatment by, e.g., irradiation with energy rays, if necessary. The solvent may be volatilized by, e.g., heating the applied coating liquid (2) for a specific time in a specific temperature range. The heating temperature is preferably 40 to 200°C and more preferably 40 to 140°C. The heating time is preferably 15 to 600 seconds.

After the light diffusion adhesive layer is formed, a separator may be attached to the light diffusion adhesive layer, if necessary. Upon production of a surface light source device, the separator is removed immediately before the optical sheet of the present invention is attached to another layer. In this manner, attachment of the optical sheet can be easily achieved.

<Surface light source device>

The surface light source device of the present invention includes the optical sheet of the present invention and an organic EL element.

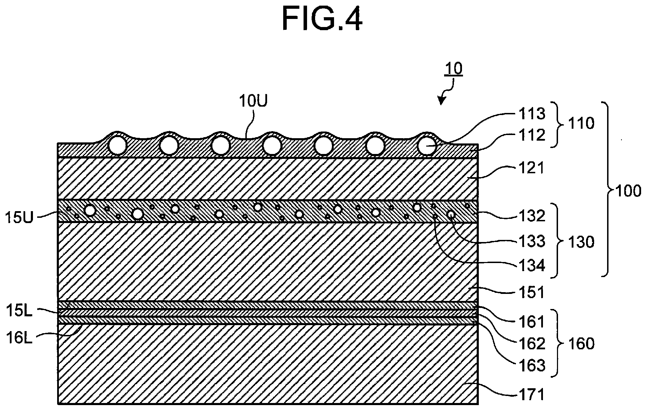

FIG. 4 is a cross-sectional view schematically illustrating an example of the surface light source device of the present invention including the optical sheet 100 of the present invention shown in FIG. 1.

The surface light source device 10 has a flat plate-shaped structure and includes: a substrate 151 formed of a material such as glass; the optical sheet 100 of the present invention disposed in contact with a surface 15U that is a surface on a device light-emitting surface side of the substrate 151; and an organic EL element 160 disposed in contact with the other surface 15L of the substrate 151. The surface light source device 10 further includes, as an optional constituent, a sealing substrate 171 disposed on a surface 16L of the organic EL element 160 that is opposite to the device light-emitting surface. As the substrate 151, high-refractive index glass having a refractive index of 1.6 or higher is preferably used. Use of the substrate having such a high refractive index improves the efficiency of light extraction from the organic EL element 160 to the substrate. No particular limitation is imposed on the upper limit of the refractive index of the high-refractive index glass, although the refractive index may be 2.5 or lower.

The organic EL element 160 includes a first electrode layer 161, a light-emitting layer 162, and a second electrode layer 163 in this order from the side close to the substrate 151. The first electrode layer 161 is a transparent electrode, and the second electrode layer 163 is a reflecting electrode. With the aforementioned configuration, light from the light-emitting layer 162 passes through the first electrode layer 161 or is reflected at the second electrode layer 163 and then passes through the light-emitting layer 162 and the first electrode layer 161, to direct toward the optical sheet 100.

The optical sheet 100 is disposed such that the light diffusion layer 110 is located at the upper surface of the surface light source device 10 (i.e., the outermost layer on the light-emitting surface side of the surface light source device 10) and the light diffusion adhesive layer 130 is in contact with the substrate 151. The function of the light diffusion adhesive layer 130 as an adhesive layer enables the optical sheet 100 to adhere to the substrate 151.

The light emitted from the organic EL element 160 toward the device light-emitting surface enters the substrate 151 and then enters the light diffusion adhesive layer 130. Since the light diffusion adhesive layer 130 contains the high-refractive index nanoparticles 134 and has a high refractive index as the entire layer, high efficiency of light extraction from the substrate 151 to the light diffusion adhesive layer can be obtained. Since the light diffusion adhesive layer 130 contains the second diffusion particles 133, the traveling direction of light is diffused. The second diffusion particles 133 are preferably particles having a number average particle diameter of 0.3 to 1.7 $\mu$m, whereby the light is diffused over a wide angle even with relatively low haze state. Since a large amount of particles are contained, unevenness occurs in the light diffusion adhesive layer 130. However, the haze of the light diffusion adhesive layer 130 itself is at a low value and is relatively lower than the haze value of the light diffusion layer 110. Therefore, the degree of influence of the unevenness in the light diffusion adhesive layer 130 on its surface appearance observed at the device light-emitting surface (i.e., the surface of the light diffusion layer 110) 10U is small. Since the light is highly diffused, the efficiency of light extraction from the light diffusion adhesive layer 130 to the transparent substrate 121 can be improved even though the transparent substrate 121 has a refractive index lower than that of the light diffusion adhesive layer 130. Since the light diffusion layer 110 has the first diffusion particles 113 and the surface concavo-convex structure and has a high haze, the efficiency of light extraction from the device light-emitting surface 10U to the outside of the device can be improved, and a good surface appearance can be obtained when the surface appearance of the device is observed at the device light-emitting surface 10U.

In this manner, in the surface light source device of the present invention, the features of the constituents are combined to exert effects, and the effects of the present invention can thereby be obtained.

(Organic EL element)

As exemplified as the organic EL element 160, the organic EL element for use in the surface light source device of the present invention may be an element including at least two or more electrode layers and a light-emitting layer that is disposed between these electrode layers and emits light when electric voltage is applied through the electrodes.

Generally, the organic EL element has a configuration in which layers such as electrodes and a light-emitting layer that constitute the element are formed on a substrate and a sealing member covering these components is disposed on these components to thereby seal the layers such as the light-emitting layer between the substrate and the sealing member. An element that emits light from the substrate side is usually referred to as a bottom emission type element, and an element that emits light from the sealing member side is usually referred to as a top emission type element. The surface light source device of the present invention may be any of these types. When the organic EL element is of the bottom emission type, the optical sheet of the present invention may be disposed on the surface of the substrate opposite to the surface on which the organic EL element is formed. When the organic EL element is of the top emission type, the surface light source device can be configured by using, as the sealing member, the optical sheet of the present invention or a combination of the optical sheet of the present invention and any layer having sealing ability.

In the present invention, no particular limitation is imposed on the light-emitting layer constituting the organic EL element, and any known light-emitting layer may be appropriately selected. The number of light-emitting material types in the light-emitting layer is not limited to one, and the number of light-emitting layers is not limited to one. For adaptation to use as a light source, a single layer or a combination of a plurality of layers may be used. In this manner, the color of light emitted may be set to white or a color close to white.

The organic EL element may further include, between the electrodes, other layers than the light-emitting layer, such as a hole injection layer, a hole transport layer, an electron transport layer, an electron injection layer, and a gas barrier layer. The organic EL element may further include optional constituents such as wiring leads for applying electric current to the electrodes, and a peripheral structure for sealing the light-emitting layer.

No particular limitation is imposed on the electrodes of the organic EL element, and any known electrodes may be appropriately selected. When the electrode on the side toward the light-emitting surface structure layer is a transparent electrode and the electrode on the opposite side is a reflecting electrode as in the organic EL element 160 shown in FIG. 4, the organic EL element may be configured to emit light toward the light-emitting surface structure layer. Light emission toward the light-emitting surface structure layer may also be achieved by using transparent electrodes as both the electrodes and disposing a reflecting member on the side opposite to the light-emitting surface structure layer.

No particular limitation is imposed on the materials for constituting the electrodes and the layers disposed therebetween. Specific examples of such materials are as follows.

Examples of the material of the transparent electrode may include ITO.

Examples of the material of the hole injection layer may include starburst aromatic diamine compounds.

Examples of the material of the hole transport layer may include triphenyldiamine derivatives.

Similarly, examples of the host material of a yellow light-emitting layer may include triphenyldiamine derivatives. Examples of a dopant material of the yellow light-emitting layer may include tetracene derivatives.

Examples of the material of a green light-emitting layer may include pyrazoline derivatives.

Examples of the host material of a blue light-emitting layer may include anthracene derivatives, and examples of a dopant material of the blue light-emitting layer may include perylene derivatives.

Examples of the material of a red light-emitting layer may include europium complexes.

Examples of the material of the electron transport layer may include aluminum quinoline complexes (Alq).

Examples of the material of a cathode may include a layered body of lithium fluoride and aluminum layers that is produced by sequentially depositing these materials by vacuum deposition.

The aforementioned light-emitting layers and other light-emitting layers may be suitably combined to form a light-emitting layer that is referred to as a multilayered or tandem type that generates light having complementary colors. The combination of complementary colors may be yellow-blue, green-blue-red, etc.

(Applications of surface light source device)

The surface light source device of the present invention may be used for applications such as lighting device and backlight device applications.

The lighting device includes the surface light source device of the present invention as a light source and may further include optional constituents such as a member for holding the light source and a circuit for supplying electric power. The backlight device includes the surface light source device of the present invention as a light source and may further include optional constituents such as an enclosure, and a circuit for supplying electric power, as well as a diffusion plate, a diffusion sheet and a prism sheet for further improving the uniformity of the emitted light. The applications of the backlight device may include backlights for display devices for displaying images by controlling pixels such as liquid crystal display devices, and backlights for display devices for displaying still images such as signboards.

(Others)

The present invention is not limited to the aforementioned specific examples, and any modifications may be made within the scope of the claims of the present application and the scope of equivalents thereto.
For example, the optical sheet of the present invention may further include an optional layer, in addition to the transparent substrate, the light diffusion layer, and the light diffusion adhesive layer. The optional layer may be a layer located between any of the transparent substrate, the light diffusion layer, and the light diffusion adhesive layer and may also be, e.g., a coating layer disposed on the concavo-convex structure on the surface of the light diffusion layer. The coating layer may define the concavo-convex structure on the device light-emitting surface of the surface light source device of the present invention.
A device having the same effects as those of the device having the reflecting electrode layer may be configured when the reflecting electrode layer in any of the aforementioned specific examples is replaced with a combination of a transparent electrode layer and a reflecting layer.

[Examples]

The present invention will be described more specifically hereinbelow with reference to Examples and Comparative Examples. However, the present invention is not limited thereto. Unless otherwise specified, the amount ratio values of the materials in the following Examples are in weight ratio. Unless otherwise specified, operations in the Examples and Comparative Examples were performed in the environment of room temperature and normal pressure.
In the following Examples and Comparative Examples, properties were evaluated as follows.

(Haze)

Haze was measured using a turbidimeter (NDH-4000 manufactured by NIPPON DENSHOKU INDUSTRIES Co., Ltd.) in accordance with JIS K7105.

(Refractive index)

The refractive index of each layer was measured as follows. A single layer containing no diffusion particles or a glass substrate with the material to be measured applied thereonto was produced, and the refractive index was measured using a spectroscopic ellipsometer (M-2000, manufactured by J. A. Woollam Co., Inc.).

(Surface appearance)

The surface appearance of a film was determined as follows. The film was placed on a black plate and visually observed in a general lighting environment (about 800 Lx) to determine whether density unevenness was observed or not. When density unevenness was observed, the film was judged as NG. When no density unevenness was observed, the film was judged as OK.

(Light extraction efficiency)

Light extraction efficiency was measured using a highspeed light distribution measurement system Imaging Sphere (manufactured by PROMETRIC). Specifically, the ratio of light fluxes before and after an optical sheet described in the present application was provided was measured under the same electric current application conditions for light emission. In the Examples and Comparative Examples 1 to 3, a relative value with respect to the value in Comparative Example 4 defined as 1 was determined.

(Color change Δxy)

Color unevenness at different viewing angles was measured as follows.
A spectral radiance meter (BM-5, manufactured by TOPCON Corporation) was placed in the direction normal to the device light-emitting surface of a surface light source device, and a constant current of 100 mA/m$^2$ was applied to the surface light source device. Chromaticity (x, y) was measured while the light-emitting surface was rotated to change the observation direction of the spectral radiance meter with respect to the light-emitting surface. The observation direction was changed in a direction parallel to the long edges of the light-emitting surface within the range of -90 to 90° with respect to the front direction (the normal direction) defined as 0°, and the amount of change Δxy in chromaticity (x, y) within the observation angle range of ±60° was determined.

<Example 1>

(1-1. Coating liquid (1))

Particles (silicone resin, refractive index: 1.43) having a number average particle diameter of 4.5 μm as the first diffusion particles were added to a resin (a UV curable resin composed mainly of urethane acrylate, refractive index after curing: 1.54), and the mixture was stirred to disperse the particles, whereby a coating liquid (1) as the material of the light diffusion layer was prepared. The containing ratio of the particles with respect to the total weight of the coating liquid (1) was 50% by weight.

(1-2. Coating liquid (2))

A resin (refractive index: 1.48) composed mainly of an acid-modified polyolefin polymer as a binder was dissolved in a solvent prepared by mixing methylcyclohexane and ethyl acetate at 8:2 (weight ratio). Then particles (silicone resin, refractive index: 1.43) having a number average particle diameter of 0.6 μm as the second diffusion particles and zirconia particles (number average particle diameter: 20 nm, refractive index: 1.9) as the high-refractive index nanoparticles were added to the mixture. The resultant mixture was stirred to disperse the particles, whereby a coating liquid (2) as the material of the light diffusion adhesive layer was prepared. The concentration of the solid content (the total of the resin, the second diffusion particles, and the high-refractive index nanoparticles) in the coating liquid (2) was adjusted to 40% by weight. The concentration of the second diffusion particles with respect to the total solid content was 9% by weight, and the concentration of the high-refractive index nanoparticles with respect to the total solid content was 65% by weight.

(1-3. Formation of light diffusion adhesive layer)

The coating liquid (2) was applied onto a substrate film (polyester film) by two separate applying operations, and the solvent was volatilized to form a 20 μm-thick light diffusion adhesive layer. A separator was laminated onto the light diffusion adhesive layer to thereby obtain a multilayer film 1 having a layer structure of (substrate film) - (light diffusion adhesive layer) - (separator). The haze (i.e., the haze x2) of the multilayer film 1 was measured and found to be 70%.

(1-4. Examination of refractive index)

A coating liquid (3) for examination of refractive index was prepared in the same manner as in step (1-2) except that no second diffusion particles were added. The using amounts of all of the components other than the second diffusion particles were the same as those in step (1-2).

A multilayer film 2 having a layer structure of (substrate film) - (adhesive layer) - (separator) as a sample for examination of refractive index was obtained in the same manner as in step (1-3) except that the coating liquid (3) was used in place of the coating liquid (2). The refractive index of the adhesive layer in the multilayer film 2 (i.e., the refractive index n1) was 1.66 and was sufficiently higher than the refractive index n2 of the second diffusion particles.

(1-5. Formation of light diffusion layer)

The coating liquid (1) obtained in step (1-1) was applied onto the surface of the exposed substrate film of the multilayer film 1 obtained in step (1-3), to form a layer of the coating liquid (1). This layer was irradiated with ultraviolet rays at 1 J/cm$^2$ through the separator, the adhesive layer, and the substrate film to cure the layer. A light diffusion layer was thereby formed, and an optical sheet 1 with the separator and having a layer structure of (light diffusion layer) - (substrate film) - (light diffusion adhesive layer) - (separator) was obtained. The thickness of the obtained light diffusion layer was 15 μm. A concavo-convex structure with Ra = 1 μm was formed on the surface of the light diffusion layer.

(1-6. Haze of light diffusion layer)

Separately from step (1-5), an examination sample layered body was produced by forming a light diffusion layer in the same manner as in step (1-5) on a substrate film that is the same as that prepared in step (1-3). The haze (i.e., the haze x1) of the examination sample layered body was measured and found to be 99%.

(1-7. Formation of organic EL element)

A transparent electrode layer of 100 nm, a hole transport layer of 10 nm, a yellow light-emitting layer of 20 nm, a blue light-emitting layer of 15 nm, an electron transport layer of 15 nm, an electron injection layer of 1 nm, and a reflecting electrode layer of 100 nm were formed in this order on one main surface of a glass substrate (refractive index: 1.7) having a thickness of 0.7 mm. All of the layers from the hole transport layer to the electron transport layer were formed using organic materials. The yellow light-emitting layer and the blue light-emitting layer have different light-emission spectra.

The materials for forming each of the layers from the transparent electrode layer to the reflecting electrode layer were as follows.

Transparent electrode layer: tin-doped indium oxide (ITO)
Hole transport layer: 4,4'-bis[N-(naphthyl)-N-phenylamino]biphenyl ($\alpha$-NPD)
Yellow light-emitting layer: $\alpha$-NPD containing 1.5% by weight of rubrene
Blue light-emitting layer: 4,4'-dicarbazolyl-1,1'-biphenyl (CBP) containing 10% by weight of iridium complex
Electron transport layer: phenanthroline derivative (BCP)
Electron injection layer: lithium fluoride (LiF)
Reflecting electrode layer: Al

The transparent electrode layer was formed by a reactive sputtering method using an ITO target, and the surface resistance was 10 $\Omega$/square or smaller. The layers from the hole injection layer to the reflecting electrode layer were formed by placing in a vacuum deposition system the glass substrate having the transparent electrode layer previously formed thereon, and then the materials for the layers from the hole transport layer to the reflecting electrode layer were successively vapor-deposited by resistance heating. The pressure inside the system was 5 x 10$^{-3}$ Pa, and the evaporation rates were 0.1 to 0.2 nm/s.

Wiring leads for applying electric current were attached to the electrode layers. The layers from the hole transport layer to the reflecting electrode layer were sealed with a sealing member, to thereby obtain an organic EL element.

(1-8. Surface light source device)

The separator was removed from the optical sheet 1 with the separator that was obtained in step (1-5), and the remaining optical sheet 1 was attached to the glass substrate of the organic EL element obtained in step (1-7). The attaching was performed such that the exposed light diffusion adhesive layer adhered to the glass substrate. A surface light source device was thereby obtained. The obtained surface light source device had a rectangular light-emitting surface capable of emitting white light through the light diffusion layer of the optical sheet 1.

(1-9. Evaluation)

The surface light source device obtained in step (1-8) was evaluated for its surface unevenness, light extraction efficiency, and a color change $\Delta xy$ at different observation angles. The results are shown in Table 1.

<Example 2>

An optical sheet, a surface light source device, and other examination samples were produced and evaluated in the same manner as in steps (1-1) to (1-9) in Example 1 except that, in step (1-1), particles (silicone resin, refractive index: 1.43) having a number average particle diameter of 1.7 $\mu$m were used as the first diffusion particles in place of the particles having a number average particle diameter of 4.5 $\mu$m. The results are shown in Table 1.

In this Example, the thickness of the light diffusion layer obtained in step (1-5) was 15 $\mu$m, and a concavo-convex structure with Ra = 0.3 $\mu$m was formed on the surface of the light diffusion layer.

<Comparative Example 1>

An optical sheet, a surface light source device, and other examination samples were produced and evaluated in the same manner as in steps (1-1) to (1-9) in Example 1 except for the following changes. The results are shown in Table 1.

In step (1-1), particles (refractive index: 1.43) having a number average particle diameter of 0.6 $\mu$m were used as the first diffusion particles in place of the particles having a number average particle diameter of 4.5 $\mu$m.

In step (1-2), particles (refractive index: 1.43) having a number average particle diameter of 1.7 $\mu$m were used

as the second diffusion particles in place of the particles having a number average particle diameter of 0.6 μm. The concentration of the second diffusion particles with respect to the total solid content was 5% by weight.

In this Comparative Example, the refractive index n1 of the adhesive layer in the multilayer film 2 obtained in step (1-4) was 1.66. The thickness of the light diffusion layer obtained in step (1-5) was 15 μm, and the surface of the light diffusion layer was flat.

<Comparative Example 2>

An optical sheet, a surface light source device, and other examination samples were produced and evaluated in the same manner as in steps (1-1) to (1-9) in Example 1 except for the following changes. The results are shown in Table 1.

In step (1-1), particles (refractive index: 1.43) having a number average particle diameter of 0.6 μm were used as the first diffusion particles in place of the particles having a number average particle diameter of 4.5 μm.

In step (1-2), particles (silicone resin, refractive index: 1.43) having a number average particle diameter of 4 μm were used as the second diffusion particles in place of the particles having a number average particle diameter of 0.6 μm. The concentration of the second diffusion particles with respect to the total solid content was 5% by weight.

In this Comparative Example, the refractive index n1 of the adhesive layer in the multilayer film 2 obtained in step (1-4) was 1.66. The thickness of the light diffusion layer obtained in step (1-5) was 15 μm, and the surface of the light diffusion layer was flat.

<Comparative Example 3>

An optical sheet, a surface light source device, and other examination samples were produced and evaluated in the same manner as in steps (1-1) to (1-9) in Example 1 except for the following changes. The results are shown in Table 1.

In step (1-2), no high-refractive index nanoparticles were added.

In step (1-2), particles (silicone resin, refractive index: 1.43) having a number average particle diameter of 4 μm were used as the second diffusion particles in place of the particles having a number average particle diameter of 0.6 μm. The concentration of the second diffusion particles with respect to solid content was the same as that in step (1-2). The concentration of the second diffusion particles with respect to the total solid content was 25% by weight.

In this Comparative Example, the refractive index n1 of the adhesive layer in the multilayer film 2 obtained in step (1-4) was 1.48. The thickness of the light diffusion layer obtained in step (1-5) was 15 μm, and a concavo-convex structure with Ra = 1 μm was formed on the surface of the light diffusion layer.

<Comparative Example 4>

The organic EL element obtained in step (1-7) in Example 1, as it was, was used as a surface light source device, and the amount of change Δxy in chromaticity (x, y) was measured in the same manner as in step (1-9). The light extraction efficiency was also measured, and the light extraction efficiency in each of Examples and other Comparative Examples was represented as a relative value with respect to this measured value defined as 1. The results are shown in Table 1.

Table 1

| | Haze x1 | Haze x2 | Particle diameter of first diffusion particles | Particle diameter of second diffusion particles | Surface unevenness | Light extraction efficiency | Color change Δxy |
|---|---|---|---|---|---|---|---|
| Ex. 1 | 99% | 70% | 4.5 | 0.6 | OK | 1.5 | 0.01 |
| Ex. 2 | 98.7 % | 70% | 1.7 | 0.6 | OK | 1.48 | 0.01 |
| Comp. Ex. 1 | 86% | 80% | 0.6 | 1.7 | OK | 1.4 | 0.02 |
| Comp. Ex. 2 | 86% | 90% | 0.6 | 4 | NG | 1.4 | 0.02 |
| Comp. Ex. 3 | 99% | 93% | 4.5 | 4 | OK | 1.35 | 0.02 |

(continued)

|  | Haze x1 | Haze x2 | Particle diameter of first diffusion particles | Particle diameter of second diffusion particles | Surface unevenn ess | Light extracti on efficien cy | Color change △xy |
|---|---|---|---|---|---|---|---|
| Comp. Ex. 4 | - | - | - | - | - | 1 | 0.07 |

As is clear from the results in Table 1, the surface appearance and optical properties were good in each of Examples 1 and 2 that meet the requirements of the present invention.

In Comparative Example 1 in which the number average particle diameter of the first diffusion particles is outside the range defined in the present application, the light extraction efficiency was insufficient.

In Comparative Example 2 in which the number average particle diameter of the first diffusion particles is outside the range defined in the present application and the relationship between the haze x1 and the haze x2 does not meet the requirements of the present application, the light extraction efficiency was insufficient, and significant surface unevenness due to the light diffusion adhesive layer was visually observed. Thus the resulting surface light source device had a large degree of unevenness.

In Comparative Example 3 in which no high-refractive index nanoparticles are added, a light-emitting surface with no unevenness was obtainable. However, the light extraction efficiency at the boundary with the glass substrate could not be increased only by the second diffusion particles, so that the light extraction efficiency was significantly low.

Description of Numerals:

10: Surface light source device
10U: Device light-emitting surface, surface of light diffusion layer
20: Surface light source device
20U: Surface of light diffusion layer
100: Optical sheet
110: Light diffusion layer
112: Resin
113: First diffusion particles
121: Transparent substrate
130: Light diffusion adhesive layer
132: Binder
133: Second diffusion particles
134: High-refractive index nanoparticles
141: Separator
151: Substrate
160: Organic EL element
161: First electrode layer
162: Light-emitting layer
163: Second electrode layer
171: Sealing substrate
200: Optical sheet
210: Light diffusion layer
214: Flat portions
215: Concave portions

**Claims**

1. An optical sheet (100) comprising a transparent substrate (121), a light diffusion layer (110) having a concavo-convex surface structure and disposed on one side of the transparent substrate (121), and a light diffusion adhesive layer (130) disposed on the other side of the transparent substrate (121), wherein
the light diffusion layer (110) contains a resin (112) and first diffusion particles (113) having a number average particle diameter of 1.7 μm or more,
the light diffusion adhesive layer (130) contains a binder (132), high-refractive index nanoparticles (134), and second diffusion particles (133),
a haze x1(%) of the light diffusion layer (110) and a haze x2(%) of the light diffusion adhesive layer (130) satisfy a relationship x1 > x2,
the haze x1 is 98.5% or higher, and
the high-refractive index nanoparticles (134) are particles having a refractive index of 1.68 or higher.

2. The optical sheet according to claim, wherein the second diffusion particles (133) have a number average particle diameter of 0.3 to 1.7 μm.

3. The optical sheet according to any one of claims 1 to 2, wherein the high-refractive index nanoparticles (134) are particles formed of an inorganic material or particles each having a core formed of an inorganic material and an organic coating covering an outer surface of the core, and the second diffusion particles (133) are particles formed of an organic material.

4. The optical sheet according to any one of claims 1 to 3, wherein the second diffusion particles (133) are particles having a refractive index of lower than 1.55.

5. The optical sheet according to any one of claims 1 to 4, wherein, in the light diffusion adhesive layer (130), a refractive index n2 of the second diffusion particles (133) and a refractive index n1 of the rest of the components of the light diffusion adhesive layer (130) satisfy a relationship n1 > n2.

6. A surface light source device comprising the optical sheet according to any one of claims 1 to 5 and an organic electroluminescent light-emitting element.


**Patentansprüche**

1. Optische Folie (100) umfassend ein transparentes Substrat (121), eine lichtstreuende Schicht (110) mit einer konkav-konvexen Oberflächenstruktur, wobei die lichtstreuende Schicht auf einer Seite des transparenten Substrats (121) angeordnet ist, und eine lichtstreuende Klebeschicht (130), die auf der anderen Seite des transparenten Substrats (121) angeordnet ist, wobei
die lichtstreuende Schicht (110) ein Harz (112) und erste streuende Teilchen (113) mit einem zahlenmittleren Teilchendurchmesser von 1,7 μm oder mehr enthält,
die lichtstreuende Klebeschicht (130) ein Bindemittel (132), Nanoteilchen (134) mit hohem Brechungsindex und zweite streuende Teilchen (133) enthält,
die Trübung x1(%) der lichtstreuenden Schicht (110) und die Trübung x2(%) der lichtstreuenden Klebeschicht (130) die Relation x1 > x2 erfüllen,
die Trübung x1 98,5% oder mehr beträgt und
die Nanoteilchen (134) mit hohem Brechungsindex Teilchen mit einem Brechungsindex von 1,68 oder mehr sind.

2. Optische Folie gemäß Anspruch 1, wobei die zweiten streuenden Teilchen (133) einen zahlenmittleren Teilchendurchmesser von 0,3 bis 1,7 μm aufweisen.

3. Optische Folie gemäß einem der Ansprüche 1 bis 2, wobei die Nanoteilchen (134) mit hohem Brechungsindex Teilchen sind, die aus einem anorganischen Material gebildet sind, oder Teilchen sind, die jeweils einen Kern, der aus einem anorganischen Material gebildet ist, und eine organische Beschichtung, die eine äußere Oberfläche des Kerns bedecken, aufweisen, und die zweiten streuenden Teilchen (133) Teilchen sind, die aus einem organischen Material gebildet sind.

4. Optische Folie gemäß einem der Ansprüche 1 bis 3, wobei die zweiten streuenden Teilchen (133) Teilchen sind, die einen Brechungsindex von weniger als 1,55 aufweisen.

5. Optische Folie gemäß einem der Ansprüche 1 bis 4, wobei in der lichtstreuenden Klebeschicht (130) der Brechungsindex n2 der zweiten streuenden Teilchen (133) und der Brechungsindex n1 des Rests der Komponenten der lichtstreuenden Klebeschicht (130) die Relation n1 > n2 erfüllen.

6. Flächenlichtquellenvorrichtung umfassend die optische Folie gemäß einem der Ansprüche 1 bis 5 und ein organisches elektrolumineszierendes Licht emittierendes Element.

**Revendications**

1. Feuille optique (100), comprenant un substrat transparent (121), une couche de diffusion de lumière (110) ayant une structure de surface concavo-convexe et disposée sur un côté du substrat transparent (121), et une couche adhésive de diffusion de lumière (130) disposée sur l'autre côté du substrat transparent (121), dans laquelle :

   la couche de diffusion de lumière (110) contient une résine (112) et des premières particules de diffusion (113) ayant un diamètre de particules moyen en nombre supérieur ou égal à 1,7 $\mu$m,
   la couche adhésive de diffusion de lumière (130) contient un liant (132), des nanoparticules à indice de réfraction élevé (134), et des deuxièmes particules de diffusion (133),
   un voile x1 (%) de la couche de diffusion de lumière (110) et un voile x2 (%) de la couche adhésive de diffusion de lumière (130) satisfont à une relation x1 > x2,
   le voile x1 est supérieur ou égal à 98,5%, et
   les nanoparticules à indice de réfraction élevé (134) sont des particules ayant un indice de réfraction supérieur ou égal à 1,68.

2. Feuille optique selon la revendication, dans laquelle les deuxièmes particules de diffusion (133) ont un diamètre de particules moyen en nombre compris entre 0,3 et 1,7 $\mu$m.

3. Feuille optique selon l'une quelconque des revendications 1 à 2, dans laquelle les nanoparticules à indice de réfraction élevé (134) sont des particules constituées par un matériau inorganique ou des particules comportant chacune un coeur constitué par un matériau inorganique et un revêtement organique recouvrant une surface extérieure du coeur, et les deuxièmes particules de diffusion (133) sont des particules constituées par un matériau organique.

4. Feuille optique selon l'une quelconque des revendications 1 à 3, dans laquelle les deuxièmes particules de diffusion (133) sont des particules ayant un indice de réfraction inférieur à 1,55.

5. Feuille optique selon l'une quelconque des revendications 1 à 4, dans laquelle, dans la couche adhésive de diffusion de lumière (130), un indice de réfraction n2 des deuxièmes particules de diffusion (133) et un indice de réfraction n1 du reste des composants de la couche adhésive de diffusion de lumière (130) satisfont à une relation n1 > n2.

6. Dispositif de source de lumière de surface comprenant la feuille optique selon l'une quelconque des revendications 1 à 5 et un élément émetteur de lumière électroluminescent organique.

# FIG.1

# FIG.2

# FIG.3

# FIG.4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011078092 A